# EUROPEAN PATENT SPECIFICATION

(11) **EP 1 819 021 B1**
(45) Date of publication and mention of the grant of the patent: **20.06.2018**
(21) Application number: 06425083.0
(22) Date of filing: 14.02.2006
(51) Int. Cl.: H02H 7/09, H02H 3/253, G01R 29/16, H02H 3/353, G01R 29/18, G01R 19/25, G01R 25/00

(54) **Method and device for monitoring polyphase lines and for detecting phase losses based on the phase angle between phase-to-phase voltages**
Verfahren und Vorrichtung zur Überwachung eines mehrphasigen Netzes und zur Erkennung eines Phaseausfalles basierend auf dem Phasenwinkel zwischen verketteten Spannungen
Procédé et dispositif pour surveiller un net polyphasé et pour la détection de perte de phase basé sur l'angle formée par des potentielles entres les phases

(43) Date of publication of application: 15.08.2007
(73) Proprietor: Finder S.P.A., 10040 Almese (TO) (IT)
(72) Inventor: La Rotonda, Remo, 10024 Moncalieri (TO) (IT)
(74) Representative: Robba, Pierpaolo

(56) References cited:
- EP-A1- 0 722 220
- EP-A2- 0 264 971
- EP-A2- 0 352 951
- WO-A-00/48149
- WO-A-99/27637
- JP-A- 10 290 165
- US-A- 3 633 072
- US-A- 4 346 307
- US-A- 4 751 653
- US-A- 4 752 703
- US-A- 5 319 514
- US-A- 5 337 206
- US-A- 5 978 393
- US-A1- 2001 013 771
- US-A1- 2003 071 591
- US-A1- 2003 165 037
- US-A1- 2003 189 961

## Description

### Field of the Invention

The present invention relates to a monitoring device for polyphase networks, such as a monitoring device for threephase networks that monitors the sequence and detects phase losses.

### Background art

Currently devices are known for detecting the loss of one or more phases, and/or wrong phase sequences in an electric threephase line, so as to protect the loads fed by the line in case of anomalies.

In order to detect a phase loss error by measuring the amplitude of the concatenate voltages - that is of the voltages between a phase and another phase- it would be necessary to determine an amplitude threshold value below which a phase can be regarded as lacking. To this purpose it would be necessary either a) defining a unique voltage rating for the three concatenate voltages (and in this case such threshold value would be a fraction of such nominal voltage), or b) disregarding the possibility that, if the load connected to the line is a motor, there can be a regenerated voltage, that is fed on the threephase line by the load itself. However on one hand it is observed that regenerated voltages can reach effective values up to 80% of the average of the other phases, and therefore approximately the 70-80% of a possible threshold value. On the other hand ignoring regenerated voltages, if any, would limit the field of use of the device for detecting the line anomalies. Considering moreover that generally it is desired that a threephase load protection device can be adapted to relatively wide feeding voltage ranges, measuring the amplitude of the concatenate voltages appears an unsatisfactory solution.

US2001/0013771 discloses a method for phase failure monitoring in an electronic apparatus, such as an electricity meter. According to this method, two and the same interlinked voltages of a three-phase rotary current network are detected; the phase angle between the two interlinked voltages is ascertained and compared to a predetermined limit angle; in the event of the predetermined limit angle being exceeded by the ascertained phase angle a fault signal is produced for the failure of the common reference phase between the two detected voltages. This method is based on the observation that, if two interlinked voltages of a three-phase line are monitored, and the conductor of the common phase fails, for example due to a break in a conductor, the phase difference between the two monitored interlinked voltages increases abruptly from generally 60° to about 180°, and the two interlinked voltages collapse into one plane. This method however is quite inaccurate in detecting more general unbalance situations in a three-phase line, for instance when the phase and interlinked voltages are asymmetrical but none of them is null, due for example to regenerated voltages.

Therefore an object of the present invention is providing a method and a device for monitoring and protecting feeding threephase line, allowing detection of anomalies on the threephase line, such as the loss of one or more phases, the phase asymmetry and - unbalance in presence and absence of regenerated voltages, adapting easily to a relatively wide range of line voltage ratings.

### Summary of the Invention

In a first aspect of the present invention, this object is achieved with a method having the features according to claim 1.

In a second aspect of the present invention, this object is achieved with a device having the features according to claim 5.

In a third aspect of the present invention, this object is achieved with a program for programmable logic unit having the features according to claim 13.

In a fourth aspect of the present invention, this object is achieved with a program product for a programmable logic unit having the features according to claim 14.

In the case of a threephase line, wherein it is M = 3, the matter of detecting the three phase-differences of the several pairs of concatenate voltages, allows the triangle of the line voltages -and therefore indications about anomalies, if any, of the system of line voltages- to be assessed with no need of measuring or valuing the concatenate voltage amplitudes. The present invention therefore allows devices to be manufactured for monitoring threephase or polyphase lines that can operate in quite a wide range of voltage ratings (such as between 170 and 440 Volts).

The assessment according to the invention of the M phase-differences between the M concatenate voltages of a line with a generic number of phases M (M > 1, and in particular M > 3) allows the same advantage to be achieved also in monitoring generic polyphase lines.

Further advantages achievable will appear clearer, to a person skiled in the art, from the following detailed description of a particular preferred and non-limiting embodiment, with reference to the following schematic figures.

### List of Figures

Figure 1 shows a diagram of the connection of a monitoring device, according to a particular embodiment, to a feeding threephase line and to an electric motor fed by such line;
Figure 2 shows a block diagram of the monitoring device of Figure 1;
Figure 3 shows a diagram of the phase-differences between the sinusoidal signals of the concatenate voltages and their relative square wave signals, assessed by the monitoring device of Figure 1;
Figures 4A and 4B schematically show the triangle of the voltages in a threephase line, with a symmetrical and balanced voltage system, and an asymmetric and unbalanced voltage system respectively;
Figure 5 shows the self-protection subsystem of the monitoring device of Figure 1.

### Detailed description

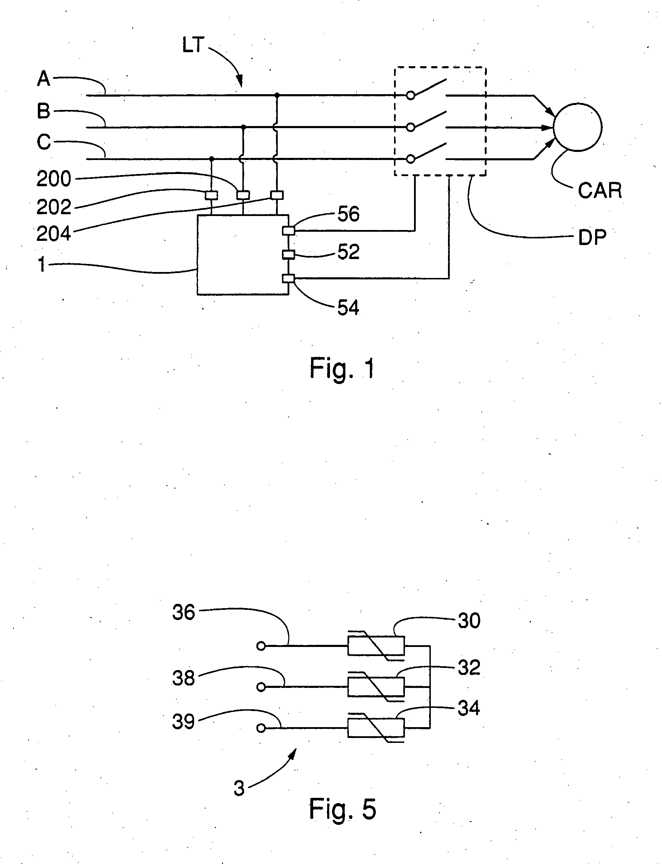

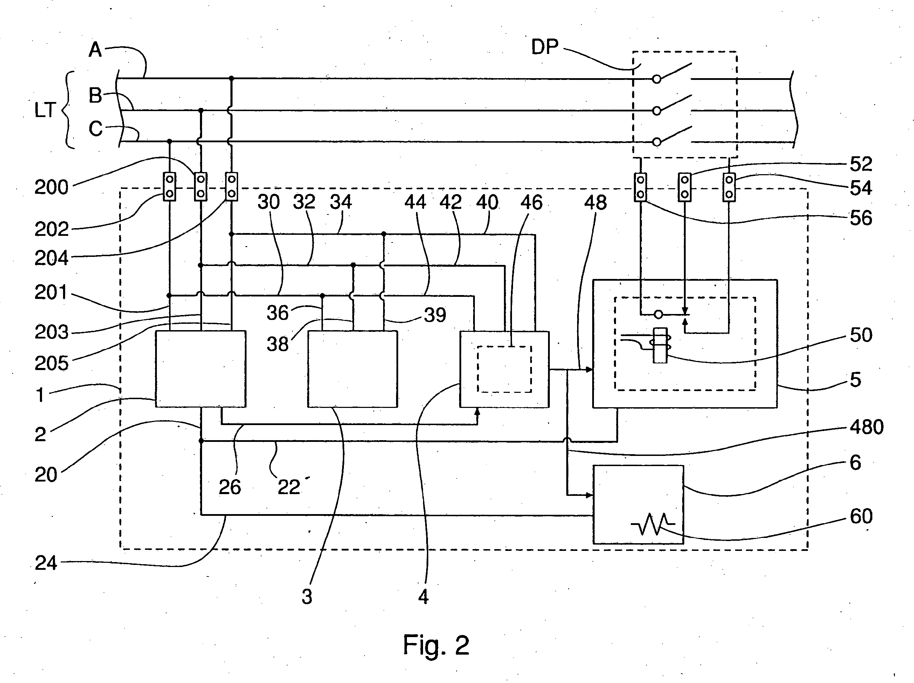

Figures 1, 2 schematically show a monitoring device of threephase lines according to a particular embodiment of the present invention, and the connection thereof to the threephase line itself and to a protection device DP controlled by the control device itself.

The references A, B, C indicate the three leads of the threephase line LT, and the reference CAR indicate a user or load device, such as an electric threephase motor, fed by the threephase line series connected with the device DP.

The monitoring device according to the present invention, referred to as with the overall reference 1, in the shown preferred embodiment is provided with five subsystems: a power supply subsystem 2, a self-protection subsystem 3, a logic unit 4, an interruptor or commutator subsystem 5 and the dummy load subsystem 6. The power supply subsystem 2, connected to the three leads A, B, C, has the task of transforming the electrical power supplied by the threephase line LT in a form - such as d.c. voltage- compatible for feeding the logic unit 4, the interruptor or commutator subsystem 5 and the dummy load 6. In the present embodiment the power supply subsystem 2:
- feeds the logic unit 4 through the monophase line 26;
- feeds the interruptor or commutator subsystem 5 through the monophase lines 20, 22; and
- feeds the dummy load subsystem 6 through the monophase lines 20, 24.

The interruptor or commutator subsystem 5 comprises a relay 50, of a type known per se, or a switch of other kinds. The subsystem 5 is controlled by the logic unit 4 through the signal line 48, as an example through a voltage driving.

In the present preferred embodiment, the logic unit 4 comprises a programmable microcontroller 46, such as the microcontroller PIC 12F675 manufactured and sold by Microchip Technology Inc., Chandler, Arizona, USA. The microcontroller 46 is connected, through the signal lines 30, 32, 34, 40, 42, 44, to the leads A, B, C of the threephase line LT, and, according to the present invention, detects the course in the time of the concatenate voltages Vab, Vac and Vbc between the different leads A, B, C through said lines.

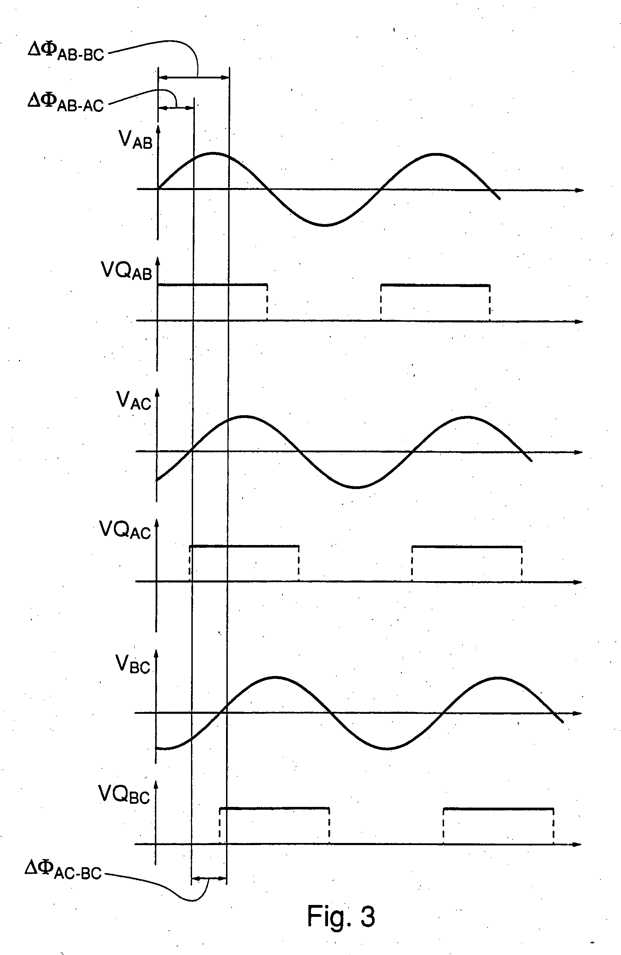

Advantageous each one of the sinusoidal sampled signals of the concatenate voltages Vab, Vac and Vbc is converted - in the present embodiment through an analogic diode circuit-in a substantially square wave signal - VQab, VQbc and VQbc respectively. In the present preferred embodiment the clipping diode circuit cuts the positive and negative peaks of the sinusoids with a sufficiently low threshold voltage- for example ± 3 Volts, or however a few Volts- in order to have a good approximation of a square wave signal (Figure 3).

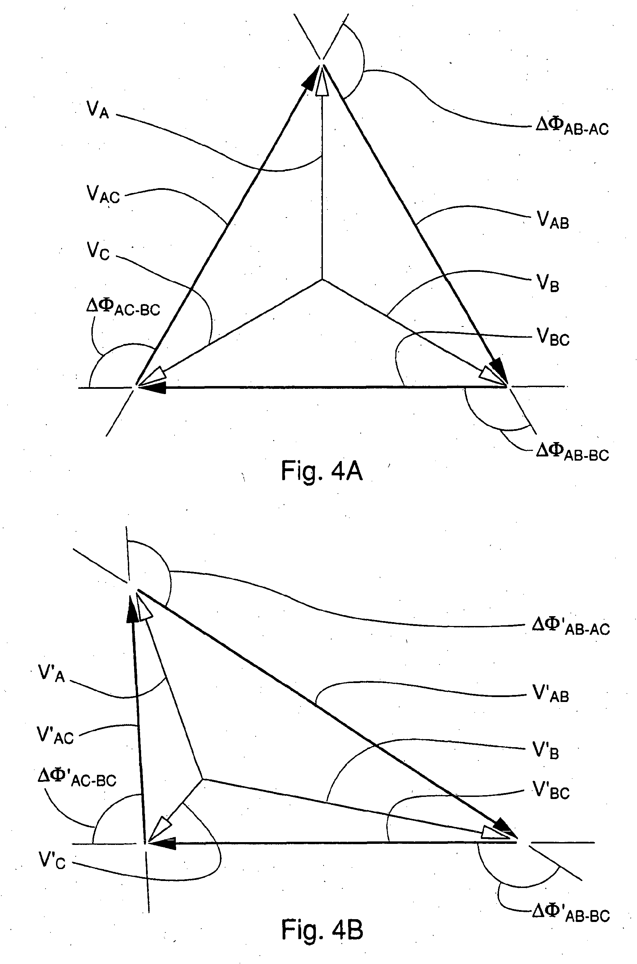

This way every square wave signal is in phase with the sinusoid of the respective concatenate voltage, and the phase difference between two square waves is substantially equal to the phase-difference between the sinusoids of the corresponding concatenate voltages. The phase differences between the sinusoids Vab and Vac, the sinusoids Vac and Vbc, and between the sinusoids Vab and Vbc, and between the corresponding square waves, are referred to as Δϕab-ac, Δϕac-bc, Δϕab-bc respectively (Figures 3, 4A, 4B). In the present example the microcontroller 46 assesses the delay between the square wave signals VQab, VQbc and VQbc through a timer, or a digital 16 bit counter. In other embodiments, the logic unit 4 can assess the delay between the square waves VQab, VQbc and VQbc through a sampling of the signals themselves, or also in other ways. Initially, the microcontroller 46 samples a suitable number of cycles and automatically obtains from them the frequency of the threephase line LT, as an example 50 or 60 hz. Depending on the frequency of the line LT and on the sampled signals VQab, VQbc and VQbc the microcontroller then deduces the phase-differences Δϕab-ac, Δϕac-bc, Δϕab-bc, and depending on such phase-differences is able to diagnose anomalies, if any, on the line LT such as a wrong phase sequence, or a phase loss in absence or presence of regenerated voltages, wherein with the wording "regenerated voltages" in the present description the voltages are meant accidentally fed in a feeding threephase line by the loads connected thereto, such as when a feeding phase lacks in a electric motor.

On one hand the wrong phase sequence can be valued analyzing in a way per se known which concatenate voltages are delayed or in advance relative to the others. On the other hand, phase-losses or phase-unbalances can be detected on the basis of the following considerations. When the threephase line LT operates in ideal conditions, with perfectly symmetrical and balanced phase voltages, the rotary vector diagram of the phase- and concatenate voltages is shown in Figure 4A, wherein the references Va, Vb and Vc indicate the vectors of the three phase voltages: the triangle of voltages is equilateral, the phase voltages shifted between each other by 120 electrical degrees (2π/3 electrical radian; in a threephase network with a 50 hz frequency, this corresponds to a delay of 6,66 ms) and the phase-differences Δϕab-ac, Δϕac-bc, Δϕab-bc between the concatenate voltages - corresponding to the 180°'s complements of the angles at the triangle vertexes are they too equal one with another and equal to 120 electrical degrees (2π/3 electrical radian). On the contrary, when the line LT operates in asymmetric conditions and unbalanced, the rotary vectors diagram of the phase- and concatenate voltages is shown in Figure 4B, wherein the vectors of the phase voltages Va, Vb and Vc are still arranged substantially symmetrical one relative another, but the triangle of the voltages is scalene or isosceles, and the phase-differences Δϕab-ac, Δϕac-bc, Δϕab-bc are generally different between each other. Therefore the microcontroller 46 can emit an anomaly indication when at least one of the phase-differences Δϕab-ac, Δϕac-bc, Δϕab-bc are different from the 60 electrical degrees taking into account suitable tolerances: as an example but not necessarily, the microcontroller 46 detects and considers as anomalous a phase-difference Δϕab-ac, Δϕac-bc, Δϕab-bc between the concatenate voltages when such phase-difference is not comprised in the range of (120 ± 24) electrical degrees; such tolerance range can be greater - for example (120 ± 48) electrical degrees, or smaller - for example (120 ± 12) electrical degrees, according to the requirements. Preferably, since a condition with a single phase-difference differing from 120 electrical degrees ± tolerance has no physical meaning as regard to the state of the line LT, the microcontroller 46 emits an anomaly indication when at least two of the phase-differences Δϕab-ac, Δϕac-bc, Δϕab-bc differ from 120 electrical degrees ± tolerance.

However activating the interruptor or commutator subsystem 5 can be not always convenient, such as opening the relay 50 at the smallest anomaly indication on threephase line LT, as an example after having found an anomalous phase-difference Δϕab-ac, or Δϕac-bc, or Δϕab-bc on a single cycle. Therefore preferably the microcontroller 46 is programmed so as to send control signals to the interruptor or commutator subsystem 5 only if he detects an anomalous phase-difference between the same pair of concatenate voltages and on a suitable number N of cycles, wherein it is N > 0, or for a predetermined waiting time Tatt (as an example it can be Tatt = 500 ms and/or N = 250 cycles). Activating the relay 50 with some delay can prevent damages or useless machine-stops of the load CAR fed by the line LT (Figure 1), allowing diagnostic system, if any, downstream of the monitoring device 1, to carry out more sophisticated evaluations and/or actions, such as disregarding the anomaly. If necessary, the waiting time Tatt can also clearly be some seconds, as an example 20 seconds or more. The previously described transformation of the sinusoidal concatenate voltages Vab, Vac, Vbc in the square wave signals VQab, VQbc and VQbc allows a greater precision in detecting the phase-differences Δϕab-ac, Δϕac-bc, Δϕab-bc between the concatenate voltages. In the device 1 according to the present preferred embodiment also the self-protection subsystem 3 is present, having the task of protecting the whole device 1 from the transient overvoltages. In the present preferred embodiment the self-protection subsystem 3 is made like an assembly of three varistors 30, 32, 34 (Figure 5) star-connected with each other, wherein each one is also connected to a different lead A, B, C of the threephase line LT through lines 36, 38, 39: the varistors absorb the transitory overvoltages not greater than a predetermined limit.

This way the self-protection subsystem 3 can be bridging-connected to other subsystems 2, 4, 5, 6; the advantage of such construction will be explained later with greater detail. Advantageously in the device 1 according to the present preferred embodiment the dummy load subsystem 6 is also present: the subsystem 6 can comprise as an example a resistor or a similar resistive load 60, that is fed, as an example with d.c. voltage, through the monophase line 20, 24 by the power supply subsystem 2, when the latter does not feed the activation of the control relay 50 or however of the interruptor or commutator subsystem 5. This increases the detection precision of the whole device 1, since this way the sudden changes of the power absorbed by the whole monitoring device 1 from the line LT, when the control relay 50, or however of the interruptor or commutator subsystem 5, is activated, are eliminated, or however remarkably reduced. This way the logic unit 4 can continue monitoring the line LT with the same precision also after that the relay 50 has been activated, without that the activation of the relay 50 causes unacceptable disturbances in the values of the concatenate voltages Vab, Vac or Vbc detected by the logic unit 4. Therefore the bridging connection of the three feeding 2-, protection 3- and logic unit 4 subsystems to the threephase line - or threephase- LT contributes to make the voltage measurements acquired by the monitoring device 1 more precise, and in general the control of device 1 more stable. Moreover, the fact that the power supply subsystem 2 is connected to and at the same time fed by all the three phases A, B, C of the line LT allows the subsystem 2 to feed the logic unit 4 also with the loss of one of the three phases, avoiding as an example that the relay 50 and the power switch DP interrupts at the smallest transitory phase loss, and possibly allowing the logic unit 4 to ignore the transitory phase loss or to intervene only after the anomaly has been detected for a predetermined time.

In the present preferred embodiment, the subsystems 1, 2, 3, 4, 5, 6 are housed in a box or another rigid housing, as an example of plastic material (not shown). From such housing or box the contacts -as an example reed-like contacts- of kind known per se, 200, 202, 204 - protrude and allow the monitoring device 1 to be connected to the leads A, B, C of the threephase line LT- and contacts 52, 54, 56, that are the output contacts of the relay 50 or however of the interruptor or commutator subsystem 5; in particular the contact 52 is the so-called "normally closed" contact, the contact 54 is the so-called "normally opened" contact and contact 56 is the so-called "common contact". In the assembly example outlined in Figure 1, the monitoring device 1 is connected at its output to the threephase switch DP through the "common-" and "normally opened" contacts (56 and 54 respectively): the opening of the relay 50 causes the power switch DP to open and the electric motor CAR to be disconnected from the line LT that feeds it The preferred embodiments previously described are susceptible of several modifications and variations without departing from the scope of the present invention as defined in the appended claims. As an example, the programmable microcontroller 46 can be replaced with other kinds of programmable- and not programmable logical units. In the present description the term "logic unit" is to be construed as comprising also an electronic computer.

## Claims

1. Method for monitoring an electric alternating current polyphase line (LT) with a number of phases greater than or equal to three, comprising the following operations:
- detecting the course of the concatenate voltages (Vab, Vac, Vbc) between a phase and another phase of said polyphaser line (LT);
- assessing the phase-differences (Δϕab-ac, Δϕac-bc, Δϕab-bc) between the different pairs (Vab-Vac; Vab-Vbc; Vac-Vbc) of said concatenate voltages;
- checking whether two or three of the phase-differences (Δϕab-ac, Δϕac-bc, Δϕab-bc) between the different pairs of said concatenate voltages are not comprised within their respective range of admissible phase-difference, in order to diagnose an anomaly condition.

2. Method according to claim 1 wherein the polyphase line is a threephase line (LT), the method comprising the following steps:
- detecting the course of the three concatenate voltages (Vab, Vac, Vbc) between a phase and another phase of said threephase line (LT);
- assessing the three phase-differences (Δϕab-ac, Δϕac-bc, Δϕab-bc) between the different pairs (Vab-Vac; Vab-Vbc; Vac-Vbc) of said concatenate voltages;
- checking whether at least two of the three phase-differences (Δϕab-ac, Δϕac-bc, Δϕab-bc) between the different pairs of said concatenate voltages are not comprised within its respective range of admissible phase-difference, in order to diagnose an anomaly condition.

3. Method according to claim 2, comprising the step of transforming each one of the courses of the different concatenate voltages (Vab, Vac, Vbc) of the threephase line substantially in a square-wave signal (Vqab, VQbc, Vqac), and assessing the three phase-differences (Δϕab-ac, Δϕac-bc, Δϕab-bc) between the different pairs of square wave signals.

4. Method according to claim 2 or 3, comprising the step of diagnosing an anomaly condition if at least two of the three phase-differences (Δϕab-ac, Δϕac-bc, Δϕab-bc) among the different pairs of concatenate voltages are not comprised within their respective range of admissible phase-difference either a) on a number of at least N cycles of the alternating current of the threephase line to be checked, wherein it is N > 1, and/or b) for at least a predetermined minimum time (Tatt).

5. Device (1) for monitoring an electric alternating current polyphase line, arranged to be connected to said polyphase line (LT) and comprising a logic unit (4) for detecting the course of the concatenate voltages (Vab, Vac, Vbc) between a phase and another phase of said polyphase line (LT), for assessing the phase-differences (Δϕab-ac, Δϕac-bc, Δϕab-bc) between the different pairs (Vab-Vac; Vab-Vbc; Vac-Vbc) of said concatenate voltages, and for checking whether two or three of the phase-differences (Δϕab-ac, Δϕac-bc, Δϕab-bc) between the different pairs of said concatenate voltages are not comprised within their respective range of admissible phase-difference, in order to diagnose an anomaly condition.

6. Device (1) according to claim 5, comprising a switch (50) controllable by the logic unit (4).

7. Device (1) according to claim 6, comprising a housing suitable for housing at least the logic unit (4), and a plurality of electrical ends which allow the switch (50) to be connected to an electric line outer to the housing so as to interrupt or commute the line by means of the switch (50).

8. Device (1) according to claim 5, comprising an analogic circuit suitable for transforming the course of each one of the concatenate voltages (Vab, Vac, Vbc) between a phase and another phase in a substantially square wave signal (VQab, VQbc, VQbc).

9. Device (1) according to one or more claims 5 to 8, wherein the logic unit (4) is arranged for being supplied at the same time by all the M phases (A, B, C) of the polyphase line (LT).

10. Device (1) according to one or more claims from 5 to 9, comprising a power supply subsystem (2) suitable for transforming the alternating polyphase current feeding, of the polyphase line (LT), in a different feeding, and suitable for feeding the logic unit (4) with said different feeding, and wherein the monitoring device is arranged for being connected to the polyphase line (LT) so that the signal connection (40, 42, 44), with which the logic unit (4) is connected to the polyphase line (LT) for detecting the course of the concatenate voltages, is parallel-connected to the connection (201, 203, 205) with which the power supply subsystem (2) is connected to and fed by the polyphase line (LT).

11. Device (1) according to one or more claims from 5 to 10, comprising a self-protection subsystem (3) suitable for protecting at least the logic unit (4) from the overvoltages fed by a polyphase feeding line (LT), and wherein the monitoring device is arranged for being connected to the feeding line (LT) so that the signal connection (40, 42, 44) with which the logic unit (4) is connected to the polyphase line (LT) for detecting the course of the concatenate voltages is parallel-connected to the connection (36, 38, 39) with which the self-protection subsystem (3) is connected to the polyphase line (LT).

12. Device (1) according at least to claim 6, comprising:
- a power supply subsystem (2) suitable for transforming the alternating polyphase current feeding, of a feeding line (LT), in a different feeding; and
- a dummy load (6, 60) suitable for absorbing substantially the same electrical power absorbed by the switch (50) when the latter is active/inactive respectively for interrupting or commuting;
wherein the monitoring device (1) is arranged so that the power supply subsystem (2) does not feed/feeds respectively the dummy load (6, 60) when the switch (50) is active/inactive respectively for interrupting or commuting, and feeds/does not feed respectively the dummy load (6, 60) when the switch (50) is inactive/active respectively for interrupting or commuting, so as to reduce the electrical absorption variations of the monitoring device (1) when the switch (50) becomes active for interrupting or commuting.

13. Program for a programmable logic unit comprising program code means arranged for carrying out all the steps of the method according to one or more claims 1 to 4 when the program is run on a programmable logic unit.

14. Program product for a programmable logic unit, comprising program code means stored on a storage medium that can be read by a programmable logic unit, wherein the program code means is arranged for carrying out the method according to one or more claims 1 to 4 when the program is run on a programmable logic unit.

## Patentansprüche

1. Verfahren zur Überwachung eines mehrphasigen Wechselstromnetzes (LT), das drei oder mehr Phasen hat, mit den folgenden Schritten:
- detektieren des Verlaufs der verknüpften Spannungen (Vab, Vac, Vbc) zwischen einer Phase und einer anderen Phase des mehrphasigen Netzes (LT);
- bewerten der Phasendifferenzen (Δϕab-ac, Δϕac-bc, Δϕab-bc) zwischen verschiedenen Paaren (Vab-Vac; Vab-Vbc; Vac-Vbc) der verknüpften Spannungen;
- prüfen ob zwei oder drei der Phasenunterschiede (Δϕab-ac, Δϕac-bc, Δϕabbc) zwischen den verschiedenen Paaren der verknüpften Spannungen nicht in ihrem jeweiligen Bereich der zulässigen Phasendifferenzen enthalten sind, um einen abnormalen Zustand zu diagnostizieren.

2. Verfahren nach Anspruch 1, wobei das mehrphasige Netz ein dreiphasiges Netz (LT) ist und das Verfahren die folgenden Schritte enthält:
- detektieren des Verlaufs der drei verknüpften Spannungen (Vab, Vac, Vbc) zwischen einer Phase und einer anderen Phase des dreiphasigen Netzes (LT);
- bewerten der drei Phasendifferenzen (Δϕab-ac, Δϕac-bc, Δϕab-bc) zwischen den verschiedenen Paaren (Vab-Vac; Vab-Vbc; Vac-Vbc) der verknüpften Spannungen;
- prüfen ob wenigstens zwei der drei Phasendifferenzen (Δϕab-ac, Δϕac-bc, Δϕab-bc) zwischen den verschiedenen Paaren der verknüpften Spannungen nicht in ihrem jeweiligen Bereich der zulässigen Phasendifferenzen enthalten sind, um einen abnormalen Zustand zu diagnostizieren.

3. Verfahren nach Anspruch 2 mit dem Schritt des Transformierens jedes der Verläufe der verschiedenen verknüpften Spannungen (Vab, Vac, Vbc) des dreiphasigen Netzes im Wesentlichen in ein Rechtecksignal (Vqab, VQbc, Vqac) und bewerten der drei Phasendifferenzen (Δϕab-ac, Δϕac-bc, Δϕab-bc) zwischen den verschiedenen Paaren der Rechtecksignale.

4. Verfahren nach Anspruch 2 oder 3 mit dem Schritt des Diagnostizieren eines abnormalen Zustands, wenn wenigstens zwei der drei Phasendifferenzen (Δϕabac, Δϕac-bc, Δϕab-bc) unter den verschiedenen Paaren der verknüpften Spannungen nicht in ihrem jeweiligen Bereich der zulässigen Phasendifferenz sind entweder a) bei einer Anzahl von wenigstens N Zyklen des Wechselstroms des zu überprüfenden dreiphasigen Netzes, wobei N > 1, und/oder b) für wenigstens eine vorgegebene Mindestzeitdauer (Tatt).

5. Vorrichtung (1) zur Überwachung eines mehrphasigen Wechselstromnetzes, das dafür eingerichtet ist, an das mehrphasige Netz (LT) angeschlossen zu werden und eine Logikeinheit (4) zum Detektieren des Verlaufs der verknüpften Spannungen (Vab, Vac, Vbc) zwischen einer Phase und einer anderen Phase des mehrphasigen Netzes (LT) aufweist, um die Phasendifferenzen (Δϕab-ac, Δϕac-bc, Δϕab-bc) zwischen den verschiedenen Paaren (Vab-Vac; Vab-Vbc; Vac-Vbc) der verknüpften Spannungen zu bewerten und zum Diagnostizieren eines abnormalen Zustands zu prüfen, ob zwei oder drei der Phasendifferenzen (Δϕab-ac, Δϕac-bc, Δϕab-bc) zwischen den verschiedenen Paaren der verknüpften Spannungen nicht in ihrem jeweiligen Bereich der zulässigen Phasendifferenz liegen.

6. Vorrichtung (1) nach Anspruch 5, mit einem Schalter (50), der von der Logikeinheit (4) gesteuert werden kann.

7. Vorrichtung (1) nach Anspruch 6, mit einem Gehäuse, das dafür geeignet ist, zumindest die Logikeinheit (4) aufzunehmen, und mit mehreren elektrischen Anschlüssen, die es ermöglichen, den Schalter (50) an eine Stromleitung außerhalb des Gehäuses anzuschließen, um die Leitung mittels des Schalters (50) zu unterbrechen oder zu verbinden.

8. Vorrichtung (1) nach Anspruch 5, mit einem analogen Schaltkreis, der dazu geeignet ist, den Verlauf von jeder der verknüpften Spannungen (Vab, Vac, Vbc) zwischen einer Phase und einer anderen Phase in ein im Wesentlichen rechteckiges Signal (VQab, VQbc, VQbc) zu transformieren.

9. Vorrichtung (1) nach einem der Ansprüche 5 bis 8, wobei die Logikeinheit (4) dafür ausgelegt ist, gleichzeitig mit allen M Phasen (A, B, C) des mehrphasigen Netzes (LT) gespeist zu werden.

10. Vorrichtung nach einem der Ansprüche 5 bis 9, mit einem Stromversorgungssubsystem (2), das dafür geeignet ist, die mehrphasigen Wechselstromeinspeisungen des mehrphasigen Netzes (LT) in eine andere Einspeisung umzuwandeln, und dafür geeignet ist, der Logikeinheit (4) die anderen Einspeisungen zu zuführen, und wobei die Überwachungsvorrichtung dafür ausgelegt ist, an das mehrphasige Netz (LT) angeschlossen zu werden, so dass der Signalanschluss (40, 42, 44), mit dem die Logikeinheit (4) an das mehrphasige Netz (LT) angeschlossen ist, um den Verlauf der verknüpften Spannungen zu erfassen, parallel zu dem Anschluss (201, 203, 205) geschaltet ist, mit dem das Stromversorgungssubsystem (2) an mehrphasige Netz (LT) angeschlossen ist und von ihm gespeist wird.

11. Vorrichtung (1) nach einem der Ansprüche 5 bis 10, mit einem eigen-geschützten Subsystem (3), das dafür geeignet ist, zumindest die Logikeinheit (4) vor Überspannungen zu schützen, die von einem mehrphasigen Netz (LT) eingespeist werden, und wobei die Überwachungsvorrichtung dafür ausgelegt ist, an das Netz (LT) angeschlossen zu werden, so dass die Signalverbindung (40, 42,44), mit der die Logikeinheit (4) an das mehrphasige Netz (LT) angeschlossen ist, um den Verlauf der verknüpften Spannungen zu erfassen, parallel zu dem Anschluss (36, 38, 39) geschaltet ist, mit dem das eigen-geschützte Subsystem (3) an das mehrphasige Netz (LT) angeschlossen ist.

12. Vorrichtung (1) zumindest nach Anspruch 6, mit:
- einem Stromversorgungssubsystem (2), das dazu geeignet ist, die Wechselstromeinspeisung eines Netzes (LT) in eine andere Einspeisung zu transformieren;
- einem Lastwiderstand (6, 60), der dazu geeignet ist, im Wesentlichen die selbe elektrische Leistung zu absorbieren, die von dem Schalter (50) absorbiert wird, wenn dieser zum Unterbrechen oder Verbinden aktiv bzw. inaktiv ist;
- wobei die Überwachungsvorrichtung (1) so ausgelegt ist, dass das Stromversorgungssubsystem (2) den Lastwiderstand (6,60) nicht speist bzw. speist, wenn der Schalter (50) zum Unterbrechen oder Verbinden jeweils aktiv/inaktiv ist, und den Lastwiderstand speist bzw. nicht speist, wenn der Schalter (50) zum Unterbrechen oder Verbinden inaktiv/aktiv ist, so dass die elektrischen Absorptionsunterschiede der Überwachungsvorrichtung (1) reduziert sind, wenn der Schalter (50) zum Unterbrechen oder Verbinden aktiviert wird.

13. Programm für eine programmierbare Logikeinheit mit Programmcodemitteln, die dafür ausgelegt ist, alle Schritte des Verfahrens nach einem der Ansprüche 1 bis 4 auszuführen, wenn das Programm auf einer programmierbaren logischen Einheit läuft.

14. Programmprodukt für eine programmierbare Logikeinheit, das Programmcodemittel aufweist, die auf einem Speichermedium gespeichert sind, das von der programmierbaren Logikeinheit gelesen werden kann, wobei die Programmcodemittel dafür ausgelegt sind, das Verfahren nach einem der Ansprüche 1 bis 4 auszuführen, wenn das Programm auf einer programmierbaren Logikeinheit läuft.

## Revendications

1. Procédé de surveillance d'une ligne polyphasée à courant alternatif électrique (LT) avec un nombre de phases supérieur ou égal à trois, comprenant les opérations suivantes :
- détecter l'évolution des tensions concaténées (Vab, Vac, Vbc) entre une phase et une autre phase de ladite ligne polyphasée (LT) ;
- évaluer des différences de phase (Δϕab-ac, Δϕac-bc, Δϕab-bc) entre les paires différentes (Vab-Vac ; Vab-Vbc ; Vac-Vbc) desdites tensions concaténées ;
- vérifier si deux ou trois des différences de phase (Δϕab-ac, Δϕac-bc, Δϕab-bc) entre les paires différentes desdites tensions concaténées ne sont pas comprises dans leur plage respective de différence de phase admissible, afin de diagnostiquer une condition d'anomalie.

2. Procédé selon la revendication 1, dans lequel la ligne polyphasée est une ligne triphasée (LT), le procédé comprenant les étapes suivantes :
- détecter l'évolution des trois tensions concaténées (Vab, Vac, Vbc) entre une phase et une autre phase de ladite ligne triphasée (LT) ;
- évaluer les trois différences de phase (Δϕab-ac, Δϕac-bc, Δϕab-bc) entre les paires différentes (Vab-Vac ; Vab-Vbc ; Vac-Vbc) desdites tensions concaténées ;
- vérifier si au moins deux des trois différences de phase (Δϕab-ac, Δϕac-bc, Δϕab-bc) entre les paires différentes desdites tensions concaténées ne sont pas comprises dans leur plage respective de différence de phase admissible, afin de diagnostiquer une condition d'anomalie.

3. Procédé selon la revendication 2, comprenant l'étape de transformation de chacune des évolutions des tensions concaténées différentes (Vab, Vac, Vbc) de la ligne triphasée sensiblement dans un signal d'onde carrée (Vqab, VQbc, Vqac), et d'évaluation des trois différences de phase (Δϕab-ac, Δϕac-bc, Δϕab-bc) entre les paires différentes de signaux d'onde carrée.

4. Procédé selon la revendication 2 ou 3, comprenant l'étape de diagnostic d'une condition d'anomalie si au moins deux des trois différences de phase (Δϕab-ac, Δϕac-bc, Δϕab-bc) parmi les paires différentes de tensions concaténées ne sont pas comprises dans leur plage respective de différence de phase admissible a) sur un nombre d'au moins N cycles du courant alternatif de la ligne triphasée à vérifier, dans lequel N > 1, et/ou b) pour au moins un temps minimal prédéterminé (Tatt).

5. Dispositif (1) de surveillance d'une ligne polyphasée à courant alternatif électrique, agencé pour être connecté à ladite ligne polyphasée (LT) et comprenant une unité logique (4) pour détecter l'évolution des tensions concaténées (Vab, Vac, Vbc) entre une phase et une autre phase de ladite ligne polyphasée (LT), pour évaluer les différences de phase (Δϕab-ac, Δϕac-bc, Δϕab-bc) entre les paires différentes (Vab-Vac ; Vab-Vbc ; Vac-Vbc) desdites tensions concaténées, et pour vérifier si deux ou trois des différences de phase (Δϕab-ac, Δϕac-bc, Δϕab-bc) entre les paires différentes desdites tensions concaténées ne sont pas comprises dans leur plage respective de différence de phase admissible, afin de diagnostiquer une condition d'anomalie.

6. Dispositif (1) selon la revendication 5, comprenant un commutateur (50) pouvant être commandé par l'unité logique (4).

7. Dispositif (1) selon la revendication 6, comprenant un boîtier adapté pour loger au moins l'unité logique (4), et une pluralité d'extrémités électriques qui permet au commutateur (50) d'être connecté à une ligne électrique externe au boîtier de façon à interrompre ou commuter la ligne au moyen du commutateur (50).

8. Dispositif (1) selon la revendication 5, comprenant un circuit analogique adapté pour transformer l'évolution de chacune des tensions concaténées (Vab, Vac, Vbc) entre une phase et une autre phase dans un signal d'onde sensiblement carrée (VQab, VQbc, VQbc).

9. Dispositif (1) selon une ou plusieurs des revendications 5 à 8, dans lequel l'unité logique (4) est agencée pour être alimentée en même temps par la totalité des M phases (A, B, C) de la ligne polyphasée (LT).

10. Dispositif (1) selon une ou plusieurs des revendications 5 à 9, comprenant un sous-système d'alimentation électrique (2) adapté pour transformer l'approvisionnement de courant polyphasé alternatif, de la ligne polyphasée (LT), en un approvisionnement différent, et adapté pour approvisionner l'unité logique (4) avec ledit approvisionnement différent, et dans lequel le dispositif de surveillance est agencé pour être connecté à la ligne polyphasée (LT) de sorte que la connexion de signal (40, 42, 44), avec laquelle l'unité logique (4) est connectée à la ligne polyphasée (LT) pour détecter l'évolution des tensions concaténées, est connectée en parallèle à la connexion (201, 203, 205) avec laquelle le sous-système d'alimentation électrique (2) est connecté à et approvisionné par la ligne polyphasée (LT).

11. Dispositif (1) selon une ou plusieurs des revendications 5 à 10, comprenant un sous-système d'auto-protection (3) adapté pour protéger au moins l'unité logique (4) des surtensions approvisionnées par une ligne d'approvisionnement polyphasée (LT), et dans lequel le dispositif de surveillance est agencé pour être connecté à la ligne d'approvisionnement (LT) de sorte que la connexion de signal (40, 42, 44) avec laquelle l'unité logique (4) est connectée à la ligne polyphasée (LT) pour détecter l'évolution des tensions concaténées est connectée en parallèle à la connexion (36, 38, 39) avec laquelle le sous-système d'auto-protection (3) est connecté à la ligne polyphasée (LT).

12. Dispositif (1) selon au moins la revendication 6, comprenant :
- un sous-système d'alimentation électrique (2) adapté pour transformer l'approvisionnement en courant polyphasé alternatif, d'une ligne d'approvisionnement (LT), en un approvisionnement différent ; et
- une charge factice (6, 60) adaptée pour absorber sensiblement la même puissance électrique absorbée par le commutateur (50) lorsque ce dernier est actif/inactif respectivement pour interrompre ou commuter ;
dans lequel le dispositif de surveillance (1) est agencé de sorte que le sous-système d'alimentation électrique (2) n'approvisionne pas/approvisionne respectivement la charge factice (6, 60) lorsque le commutateur (50) est actif/inactif respectivement pour interrompre ou commuter, et approvisionne/n'approvisionne pas respectivement la charge factice (6, 60) lorsque le commutateur (50) est inactif/actif respectivement pour interrompre ou commuter, de façon à réduire les variations d'absorption électrique du dispositif de surveillance (1) lorsque le commutateur (50) devient actif pour interrompre ou commuter.

13. Programme pour une unité logique programmable comprenant un moyen de code de programme agencé pour réaliser toutes les étapes du procédé selon une ou plusieurs des revendications 1 à 4 lorsque le programme est exécuté sur une unité logique programmable.

14. Produit programme pour une unité logique programmable, comprenant un moyen de code de programme stocké sur un support de stockage qui peut être lu par une unité logique programmable, dans lequel le moyen de code de programme est agencé pour réaliser le procédé selon une ou plusieurs des revendications 1 à 4 lorsque le programme est exécuté sur une unité logique programmable.
